Europäisches Patentamt

(19) European Patent Office

Office européen des brevets

(11) **EP 0 983 637 B1**

(12) **EUROPÄISCHE PATENTSCHRIFT**

(45) Veröffentlichungstag und Bekanntmachung des Hinweises auf die Patenterteilung:
**26.09.2001 Patentblatt 2001/39**

(21) Anmeldenummer: **98928056.5**

(22) Anmeldetag: **23.03.1998**

(51) Int Cl.⁷: **H03M 13/00**

(86) Internationale Anmeldenummer:
**PCT/DE98/00850**

(87) Internationale Veröffentlichungsnummer:
**WO 98/49778 (05.11.1998 Gazette 1998/44)**

(54) **VERFAHREN UND ANORDNUNG ZUR ERMITTLUNG MINDESTENS EINES DIGITALEN SIGNALWERTS AUS EINEM ELEKTRISCHEN SIGNAL**

METHOD AND DEVICE FOR DETERMINING AT LEAST ONE DIGITAL SIGNAL VALUE FROM AN ELECTRIC SIGNAL

PROCEDE ET DISPOSITIF POUR DETERMINER AU MOINS UNE VALEUR DE SIGNAL NUMERIQUE A PARTIR D'UN SIGNAL ELECTRIQUE

(84) Benannte Vertragsstaaten:
**DE FR GB**

(30) Priorität: **30.04.1997 DE 19718424**

(43) Veröffentlichungstag der Anmeldung:
**08.03.2000 Patentblatt 2000/10**

(73) Patentinhaber: **SIEMENS AKTIENGESELLSCHAFT 80333 München (DE)**

(72) Erfinder: **SCHÄFFLER, Stefan D-86199 Augsburg (DE)**

(56) Entgegenhaltungen:
- YOU Y -L ET AL: "BLIND EQUALIZATION BY ALTERNATING MINIMIZATION FOR APPLICATIONS TO MOBILE COMMUNICATIONS" GLOBECOM '95. IEEE GLOBAL TELECOMMUNICATIONS CONFERENCE, SINGAPORE, NOV. 14 - 16, 1995, Bd. 1, 14. November 1995, Seiten 88-92, XP000621461 INSTITUTE OF ELECTRICAL AND ELECTRONICS ENGINEERS
- RAMESH PYNDIAH ET AL: "NEAR OPTIMUM DECODING OF PRODUCT CODES" PROCEEDINGS OF THE GLOBAL TELECOMMUNICATIONS CONFERENCE (GLOBECOM), SAN FRANCISCO, NOV. 28 - DEC. 2, 1994, Bd. 1, 28. November 1994, Seiten 339-343, XP000488569 INSTITUTE OF ELECTRICAL AND ELECTRONICS ENGINEERS
- OFFER E: "SOFT-IN/SOFT-OUT DECODERS FOR LINEAR BLOCK CODES" CODIERUNG FUR QUELLE, KANAL UND UBERTRAGUNG, VORTRAGE DER ITG-FACHTAGUNG, MUNCHEN, OCT. 26 -28, 1994, Nr. 130, 1. Januar 1994, Seiten 31-40, XP000503775 INFORMATIONSTECHNISCHE GESELLSCHAFT IM VDE (ITG)

**Beschreibung**

Verfahren und Anordnung zur Ermittlung mindestens eines digitalen Signalwerts aus einem elektrischen Signal

Ziel der von Claude Shannon 1948 begründeten Informationstheorie ist es, leistungsfähige Codes zur Codierung, Übertragung und Decodierung digitaler Daten zu entwickeln und bei der Decodierung die verfügbaren Informationen der codierten Daten möglichst optimal auszunutzen.

Aus [5] ist eine Identifikation eines Übertragungskanals zur Übertragung digitaler Daten bekannt.

Aus [6] ist ein Verfahren zur gemeinsamen Viterbi-Decodierung, -Entzerrung und Kanalschätzung bekannt.

Bei der Decodierung digitaler Daten wird zwischen zwei Arten der Decodierung unterschieden:

- Bei der sog. Hard-Decision-Decodierung wird eine empfangenes, durch die Übertragung über einen Kanal verrauschtes Signal in eine Folge digitaler Daten decodiert, wobei lediglich der digitale Wert des jeweils empfangenen Signals klassifiziert wird;
- bei der sog. Soft-Decision-Decodierung wird für jedes zu decodierende Informationszeichen zusätzlich eine A posteriori-Wahrscheinlichkeit für den zu klassifizierenden Wert ermittelt. Solche A posteriori-Wahrscheinlichkeiten werden auch als Soft-Outputs bezeichnet und bilden ein Maß für die Zuverlässigkeit der Decodierung.

Im weiteren wird die Soft-Decision-Decodierung betrachtet. Grundlagen über sog. Block-Codes sind aus [2] bekannt.

Aus [3] ist es bekannt, für einen binären linearen Blockcode eine Soft-Decision-Decodierung durchzuführen.

Im weiteren wird das Verfahren aus [3] zur exakten Berechnung digitaler Signalwerte aus einem elektrischen Signal unter Verwendung der sog. Log-Likelihood-Algebra erläutert.

Im weiteren wird angenommen, daß die Ausgabe eines Quellencodierers einer ersten Anordnung aus einer Folge digitaler, vorzugsweise binärer Signalworte, die im weiteren als Codewörter bezeichnet werden, besteht. Es werden endlich viele, stochastisch unabhängige Zufallsvariablen

$$U_i: \Omega \to \{\pm 1\}, \; i = 1, ..., m \qquad m \in N \qquad (1)$$

betrachtet, die auf einem Wahrscheinlichkeitsraum $(\Omega, S, P)$ definiert sind. Mit S wird eine $\sigma$-Algebra bezeichnet, d.h. die Menge der Ereignisse, für die eine Wahrscheinlichkeit definiert ist. Mit P wird ein Wahrscheinlichkeitsmaß bezeichnet $(P: S \to [0, 1])$. Unter der Voraussetzung, daß die Ungleichungen

$$0 < P\big(\{\omega \in \Omega; U_i(\omega) = -1\}\big) < 1, \quad i = 1, \ldots, m \qquad (2)$$

erfüllt sind, werden sog. L-Werte der Zufallsvariablen $U_i$ durch

$$L(U_i) := \ln\left(\frac{P\big(\{\omega \in \Omega; U_i(\omega) = +1\}\big)}{P\big(\{\omega \in \Omega; U_i(\omega) = -1\}\big)}\right), \quad i = 1, \ldots, m \qquad (3)$$

definiert.

Codeworte $\underline{u}$ haben folgenden Aufbau:

$$\underline{u} \in \{\pm 1\}^k.$$

Dabei ist für jedes Codewort $\underline{u}$ vorausgesetzt, daß jeder digitaler Wert $u_i$, i=1...k des Codeworts $\underline{u}$, mit gleicher Wahrscheinlichkeit einen ersten Wert (logisch "0" oder logisch "+1") oder einen zweiten Wert (logisch "1" oder logisch "-1") annimmt. Da bei der Übertragung von Nachrichten mit Störungen zu rechnen ist, die die Nachrichten verfälschen können, wird ein weiterer Codierungsschritt, die Kanalcodierung, durchgeführt.

Bei der Kanalcodierung wird, wie in [1] beschrieben, den eingehenden Codewörtern $\underline{u}$ gezielt Redundanz hinzugefügt, um mögliche Übertragungsfehler korrigieren zu können und somit eine hohe Übertragungszuverlässigkeit zu sichern. Im folgenden wird davon ausgegangen, daß bei der Kanalcodierung jedem Codewort $\underline{u} \in \{\pm 1\}^k$ ein Kanalcodewort $\underline{c} \in \{\pm 1\}^n$, $n > k$, $n \in N$, zugeordnet wird. Die Ausgabe der Einrichtung zur Kanalcodierung besteht somit aus Codewörtern der Form $\underline{c} \in \{\pm 1\}^n$.

Die Kanalcodewörter werden über einen physikalischen Kanal, beispielsweise eine Teilnehmeranschlußleitung, Koaxialkabel, Mobilfunk, Richtfunk, etc., von einer Sendeeinrichtung zu einer Empfangseinrichtung übertragen.

Da der physikalische Kanal oftmals keine diskreten Symbole, sondern nur zeitkontinuierliche Signale (also spezielle Funktionen s: $\Re \to \Re$) übertragen kann, ist oftmals ein Modulator vorgesehen, durch den dem Kanalcodewort $\underline{c}$ eine für die Übertragung über den physikalischen Kanal geeignete Funktion zugeordnet wird. Eine wichtige Kenngröße des gesendeten elektrischen Signals ist die mittlere Energie $E_b$, die für die Übertragung eines Informationsbits des Kanalcodeworts $\underline{c}$ verwendet wird.

Da bei der Übertragung eines elektrischen Signals über einen physikalischen Kanal eine Störung auftreten kann, wird im allgemeinen ein elektrisches Signal $\tilde{s} : \Re \to \Re$, welches gegenüber dem gesendeten elektrischen Signal verändert ist, empfangen.

Die Störung wird mit Methoden der stochastischen Signaltheorie beschrieben. Eine Kenngröße der Störung ist die bekannte einseitige Rauschleistungsdichte $N_0$, die bestimmt ist durch den Kanal. Nach einer eventuellen Demodulation des empfangenen elektrischen Signals $\tilde{s}$ liegt anstelle des Codeworts $\underline{c}$ ein Vektor $\underline{y} \in \Re^n$ vor. Der Absolutbetrag jeder Komponente des Vektors $\underline{y}$ wird dabei als Zuverlässigkeitsinformation für das entsprechende Vorzeichen der Komponente im Rahmen der Soft-Decision-Decodierung interpretiert.

Die Kanaldecodierung hat nun die Aufgabe, unter Verwendung des empfangenen, eventuell demodulierten elektrischen Signals $\tilde{s}$, welches schließlich als Vektor $\underline{y}$ zur Verfügung steht, das Codewort $\underline{u}$, welches ursprünglich vorlag, zu rekonstruieren.

Es ist üblich, den physikalischen Kanal und dessen Störeigenschaften zu modellieren. Ein dazu häufig verwendetes Modell ist der sog. invariante AWGN-Kanal (Additive Gaussian White Noise). Im weiteren wird, wenn ein Modulator und ein Demodulator vorhanden sind, in diesem Modell die Gesamtheit von Modulator, physikalischem Kanal und Demodulator als Kanal bezeichnet. Bei dem AWGN-Kanal wird davon ausgegangen, daß die Ausgabe des Kanalcodierers, d.h. das Kanalcodewort $\underline{c}$ durch eine

$$N\left(\underline{0}, \frac{N_0 n}{2 E_b k}, \underline{I}_n\right) - \text{normal}$$

verteilte Zufallsvariable additiv überlagert wird, wobei mit $\underline{I}_n$ die n-dimensionale Einheitsmatrix bezeichnet wird. Der Quotient $\frac{N_0}{E_b}$ ist bekannt und wird auch als Signal-/Rausch-Verhältnis bezeichnet.

Durch vollständige Induktion nach m läßt sich aufgrund der stochastischen Unabhängigkeit der Zufallsvariablen $U_1,...,U_m$ zeigen, daß für den L-Wert der verketteten Zufallsvariablen $U_1 \oplus ... \oplus U_m$ gilt (mit $\oplus$ wird eine Exklusiv-Oder-Verknüpfung bezeichnet):

$$U_1 \oplus U_2 \oplus ... U_m : \Omega \to \{\pm 1\}, \omega \to U_1(\omega) \oplus U_2(\omega) \oplus ... U_m(\omega) \tag{4}$$

und

$$L\left(U_1 \oplus U_2 \oplus ... U_m\right) = \ln\left(\frac{1 + \prod_{i=1}^{m} \frac{\exp\left(L(U_i)\right) - 1}{\exp\left(L(U_i)\right) + 1}}{1 - \prod_{i=1}^{m} \frac{\exp\left(L(U_i)\right) - 1}{\exp\left(L(U_i)\right) + 1}}\right) \tag{5}.$$

Für das aus [3] bekannte Verfahren ergibt sich folgende Ausgangssituation: Gegeben sind natürliche Zahlen k, n und Mengen $J_{k+1}, ...,J_n \subseteq \{1,...,k\}$, die die Eigenschaften des Kanalcodierers beschreiben, sowie die nichtnegative

reelle Zahl $\frac{N_0}{E_b}$. Mit k wird die Anzahl digitaler Werte des Codewortes $\underline{u}$ bezeichnet. Mit n wird die Anzahl der digitalen Werte des Kanalcodewortes $\underline{c} \in \{\pm1\}^n$, mit n > k, bezeichnet. Die n-k digitalen Werte, die dem Codewort $\underline{u}$ bei der Bildung des Kanalcodewortes $\underline{c}$ hinzugefügt werden, die auch als Prüfbits bezeichnet werden, werden durch $J_{k+1},...,J_n \subseteq \{1,...,k\}$ charakterisiert.

Ferner ist ein Wahrscheinlichkeitsraum $(\Omega, S, P)$ und eine n-dimensionale Zufallsvariable C

$$\underline{C}: \Omega \to \{\pm1\}^n \qquad (6)$$

mit folgenden Eigenschaften gegeben:

- Komponenten

$$C_1, ..., C_k: \Omega \to \{\pm1\} \qquad (7)$$

der n-dimensionalen Zufallsvariable $\underline{C}$ sind stochastisch unabhängig und es gilt für alle i=1,..., k:

$$P\left(\{\omega \in \Omega; C_i(\omega) = -1\}\right) = P\left(\{\omega \in \Omega; C_i(\omega) = +1\}\right) = \frac{1}{2} \qquad (8).$$

- Für jedes $i \in \{k + 1,..., n\}$ und für alle $\omega \in \Omega$ gilt:

$$C_i(\omega) = \bigoplus_{j \in J_i} C_j(\omega) \qquad (9).$$

Die digitalen Werte, die durch die Kanalcodierung gebildet werden, d.h. die Kanalcodeworte $\underline{c}$ werden als Realisierung der Zufallsvariablen $\underline{C}$ interpretiert.

Die zu rekonstruierende Ausgabe $\hat{u}$ des Kanaldecodierers, die im weiteren als Menge digitaler Signalwerte bezeichnet wird, sind die entsprechende Realisierung der Zufallsvariablen

$$U: \Omega \to \{\pm1\}^k, \omega \mapsto (C_1(\omega), ..., C_k(\omega))^T \qquad (10),$$

Die Ausgabe

$$\underline{y} \in \mathfrak{R}^n \qquad (11).$$

der Einheit zur Demodulation bzw. der Vektor, der das elektrische Signal beschreibt und für den die Decodierung erfolgt, wird als Realisierung der Zufallsvariablen

$$\underline{Y}: \to \mathfrak{R}^n, \omega \mapsto \underline{C}(\omega) + \underline{Z}(\omega) \qquad (12)$$

interpretiert, wobei $\underline{Z}: \Omega \to \mathfrak{R}^n$ eine

$$N\left(\underline{0}, \frac{N_0 n}{2E_b k}, \underline{I}_n\right)-\text{normal}$$

verteilte Zufallsvariable ist, die stochastisch unabhängig von der n-dimensionalen Zufallsvariable $\underline{C}$ ist. Basierend auf dem das empfangene elektrische Signal beschreibenden Vektors $\underline{y}$ wird das Codewort $\hat{\underline{u}}$ rekonstruiert.

Um die einzelnen digitalen Signalwerte zu rekonstruieren, wird die Verteilung der Zufallsvariablen C unter der Bedingung untersucht, daß der das elektrische Signal beschreibende Vektor $\underline{y}$ empfangen wurde.

Die durch diese Verteilung induzierten Wahrscheinlichkeiten werden als A posteriori-Wahrscheinlichkeiten bezeichnet.

Es werden für jedes $\varepsilon > 0$ die folgenden Größen betrachtet:

$$L_\varepsilon\left(U_i \middle| \underline{y}\right) := \ln\left(\frac{P\left(\{\omega \in \Omega; U_i(\omega) = +1\} \middle| \{\omega \in \Omega; \underline{Y}(\omega) \in M_{\underline{y},\varepsilon}\}\right)}{P\left(\{\omega \in \Omega; U_i(\omega) = -1\} \middle| \{\omega \in \Omega; \underline{Y}(\omega) \in M_{\underline{y},\varepsilon}\}\right)}\right) =$$

$$= \ln\left(\frac{\displaystyle\sum_{\substack{\underline{v} \in C \\ v_i = +1}} P\left(\{\omega \in \Omega; \underline{C}(\omega) = \underline{v}\} \middle| \{\omega \in \Omega; \underline{Y}(\omega) \in M_{\underline{y},\varepsilon}\}\right)}{\displaystyle\sum_{\substack{\underline{v} \in C \\ v_i = -1}} P\left(\{\omega \in \Omega; \underline{C}(\omega) = \underline{v}\} \middle| \{\omega \in \Omega; \underline{Y}(\omega) \in M_{\underline{y},\varepsilon}\}\right)}\right)$$

$$(13).$$

Für i = 1, ..., k, wobei

$$M_{\underline{y},\varepsilon} := [y_1, y_1 + \varepsilon] \times ... \times [y_n, y_n + \varepsilon] \tag{14}$$

und C die Menge aller Kanalcodewörter $\underline{c}$ bezeichnet.

Durch Verwendung des Satzes von Bayes ergibt sich:

$$L_{\varepsilon}\big(U_i\big|\underline{y}\big) \quad := \quad \ln \left( \frac{\sum\limits_{\substack{\underline{v} \in C \\ \nu_i = +1}} P\Big(\big\{\omega \in \Omega; \underline{Y}(\omega) \in M_{\underline{y},\varepsilon}\big\}\big|\big\{\omega \in \Omega; \underline{C}(\omega) = \underline{v}\big\}\Big)}{\sum\limits_{\substack{\underline{v} \in C \\ \nu_i = -1}} P\Big(\big\{\omega \in \Omega; \underline{Y}(\omega) \in M_{\underline{y},\varepsilon}\big\}\big|\big\{\omega \in \Omega; \underline{C}(\omega) = \underline{v}\big\}\Big)} \right)$$

$$= \ln \left( \frac{\sum\limits_{\substack{\underline{v} \in C \\ \nu_i = +1}} \int\limits_{M_{\underline{y},\varepsilon}} \exp\left(- \frac{(\underline{x} - \underline{v})^T (\underline{x} - \underline{v})}{\frac{N_0 n}{E_b k}}\right) dx}{\sum\limits_{\substack{\underline{v} \in C \\ \nu_i = -1}} \int\limits_{M_{\underline{y},\varepsilon}} \exp\left(- \frac{(\underline{x} - \underline{v})^T (\underline{x} - \underline{v})}{\frac{N_0 n}{E_b k}}\right) dx} \right)$$

7

Betrachtet man durch mehrfache Verwendung der Regel von De L'Hospital den Grenzübergang von (14) für $\varepsilon \to 0$, so erhält man für jedes Zeichen die Soft-Outputs

$$L\big(U_i\big|\underline{y}\big)$$

nach folgender Vorschrift:

$$L\big(U_i\big|\underline{y}\big) = \ln \left( \frac{\sum\limits_{\substack{\underline{v} \in C \\ \nu_i = +1}} \exp\left(- \frac{(\underline{y} - \underline{v})^T (\underline{y} - \underline{v})}{\frac{N_0 n}{E_b k}}\right)}{\sum\limits_{\substack{\underline{v} \in C \\ \nu_i = -1}} \exp\left(- \frac{(\underline{y} - \underline{v})^T (\underline{y} - \underline{v})}{\frac{N_0 n}{E_b k}}\right)} \right) \qquad (16).$$

Die Soft-Outputs, die zum einen üblicherweise eine Vorzeicheninformation und eine Zuverlässigkeitsinformation (Absolutbetrag des Soft-Outputs) enthalten, werden im weiteren als Zuverlässigkeitsmaß bezeichnet.

Völlig analog erhält man für $i = k + 1,..., n$:

$$L\left(\bigoplus_{j \in J_i} U_j \Big| \underline{y}\right) = \ln \left(\frac{\sum\limits_{\substack{\underline{v} \in C \\ v_i = +1}} \exp\left(-\frac{(\underline{y} - \underline{v})^T (\underline{y} - \underline{v})}{\frac{N_0 n}{E_b k}}\right)}{\sum\limits_{\substack{\underline{v} \in C \\ v_i = -1}} \exp\left(-\frac{(\underline{y} - \underline{v})^T (\underline{y} - \underline{v})}{\frac{N_0 n}{E_b k}}\right)}\right) \qquad (17).$$

Die Deocodierung bei dem bekannten Verfahren erfolgt derart, daß für den Fall, daß das Zuverlässigkeitsmaß einen Wert größer 0 aufweist, die i-te Komponente $u_i$ des zu rekonstruierenden Codewortes $\hat{u}$ mit dem zweiten Wert (logisch "1" oder logisch "-1") rekonstruiert wird. Für einen Wert des Zuverlässigkeitsmaßes kleiner 0 wird dem digitalen Signalwert der erste Wert (logisch "0" oder logisch "+1") zugeordnet. Für den Wert des Zuverlässigkeitsmaßes gleich 0 kann man sich willkürlich für den ersten oder den zweiten Wert entscheiden. Der Absolutbetrag des Zuverlässigkeitsmaßes ist ein Maß für die Zuverlässigkeit der obigen Entscheidungsregeln. Je größer der Absolutbetrag ist, desto zuverlässiger ist die Rekonstruktion.

Nachteilig an diesem bekannten Verfahren ist der Aufwand zur rechnergestützten Ermittlung des Zuverlässigkeitsmaßes. Die Ermittlung des Zuverlässigkeitsmaßes erfordert im allgemeinen einen Aufwand an Additionen, der proportional zu $\min(2^k, 2^{n-k})$ ist. Somit ist die direkte Berechnung der Zuverlässigkeitsmaße und die Ermittlung der digitalen Werte abhängig von den Zuverlässigkeitsmaßen häufig nicht numerisch realisierbar. Für den sog. BCH(255, 191)-Code (vgl. [2]) wären für die Berechnung der 191 Zuverlässigkeitsmaße und digitalen Signalwerte ca. $10^{20}$ Additionen erforderlich.

Somit liegt der Erfindung das Problem zugrunde, ein Verfahren und eine Anordnung zur Ermittlung mindestens eines digitalen Signalwerts aus einem elektrischen Signal, welches Signalinformation und aus der Signalinformation ermittelte Redundanzinformation zu der Signalinformation enthält, anzugeben, bei denen eine gegenüber dem bekannten Verfahren vereinfachte Ermittlung möglich ist.

Das Problem wird durch das Verfahren gemäß Patentanspruch 1 sowie durch die Anordnung gemäß Patentanspruch 10 gelöst.

Bei dem Verfahren gemäß Patentanspruch 1 wird aus dem elektrischen Signal ein Zuverlässigkeitsmaß zur Bildung des Signalwertes approximiert und abhängig von dem Zuverlässigkeitsmaß der Signalwert ermittelt.

Die Anordnung gemäß Patentanspruch 10 enthält eine Recheneinheit, die derart eingerichtet ist, daß aus dem elektrischen Signal ein Zuverlässigkeitsmaß zur Bildung des Signalwertes approximiert wird und daß abhängig von dem Zuverlässigkeitsmaß der Signalwert ermittelt wird.

Ferner erfolgt bei dem Verfahren gemäß Patentanspruch 1 und bei der Anordnung gemäß Patentanspruch 10 jeweils die Approximation des Zuverlässigkeitsmaßes derart, daß eine Zielfunktion optimiert wird, wobei die Zielfunktion ein Modell eines Übertragungskanals, über den das elektrische Signal übertragen wurde, enthält.

Durch die Approximation des bisher exakt zu ermittelnden Zuverlässigkeitsmaßes, von dem abhängig der Signalwert ermittelt wird, wird eine erhebliche Vereinfachung bei der Ermittlung des digitalen Signalwertes erreicht. Dies führt zu einer erheblich schnelleren Durchführbarkeit des Verfahrens durch einen Rechner bzw. zur erheblichen Einsparung an Kosten für die Realisierung der Anordnung zur Ermittlung des digitalen Signalwerts. Damit wird häufig erst eine numerische Lösung der Soft-Decision-Decodierung überhaupt möglich.

Anschaulich ist die Erfindung darin zu sehen, daß das bisher lediglich exakt berechenbare Zuverlässigkeitsmaß approximiert wird.

Durch die Approximation des Zuverlässigkeitsmaßes durch die Optimierung der Zielfunktion ist eine sehr einfache und somit schnell durchführbare Möglichkeit angegeben, die sogar die Eigenschaften des Übertragungskanals und somit die Störeigenschaften des gestörten Signals berücksichtigt.

Die Minimierung der Zielfunktion, die als Approximationskriterium die Eigenschaften des Kanals in Form des Modells enthält, führt dazu, daß die Effizienz des Verfahrens bzw. der Anordnung erheblich verbessert wird. Durch diese Weiterbildung wird eine gegenüber bekannten Verfahren bei gleicher Bitfehlerwahrscheinlichkeit bei der Ermittlung der digitalen Signalwerte eine erhebliche Reduktion des Signal-/Rausch-Verhältnisses $\frac{N_0}{E_b}$ erreicht. Die Verbesserung des Signal/Rauschverhältnisses beträgt je nach verwendeter Kanalcodierung bis annähernd 3 dB, was der theoretisch maximal erreichbaren Verbesserung entspräche.

Schon eine Einsparung von 1 dB kann beispielsweise bei der Funkübertragung von Raumsonden zu einer Kostenersparnis von etwa 75 Mio US-$ bei dem Bau der Raumsonde führen. Somit wird auch für den Sender erhebliche Kosteneinsparung möglich, wenn die Decodierung nach dieser Weiterbildung erfolgt, bzw. die Anordnung gemäß der Weiterbildung derart eingerichtet ist, daß die Approximation durch Optimierung einer Zielfunktion, die ein Modell des Übertragungskanals enthält, erfolgt, erreicht wird.

Vorteilhafte Weiterbildungen der Erfindung ergeben sich aus den abhängigen Ansprüchen.

Ferner ist es in einer Weiterbildung sowohl des Verfahrens als auch der Anordnung vorteilhaft, daß die Zielfunktion nach folgender Vorschrift gebildet wird:

$$f = \sum_{i=1}^{k} \left( \beta_i - \frac{4E_b k}{N_O n} Y_i \right)^2 + \sum_{i=k+1}^{n} \left( \ln \left( \frac{1 + \prod_{j \varepsilon J_i} \frac{\exp(\beta_j) - 1}{\exp(\beta_j) + 1}}{1 - \prod_{j \varepsilon J_i} \frac{\exp(\beta_j) - 1}{\exp(\beta_j) + 1}} \right) - \frac{4E_b k}{N_O n} Y_i \right)^2$$

Hierbei ist eine veränderte Skalierung oder eine leichte Abänderung und Vernachlässigung einiger Werte in der Zielfunktion sowie der Grad der Zählerfunktion (Grad der Zielfunktion) nicht wesentlich und kann beliebig verändert werden.

Durch diese Zielfunktion ist ein Modell angegeben für den Übertragungskanal, in dem die angenommenen Modelleigenschaften des Übertragungskanals berücksichtigt wird, was bei Optimierung der Zielfunktion, beispielsweise einer Minimierung der Fehlerfunktion sehr gute Ergebnisse bei der Ermittlung der Signalwerte nach der Optimierung liefert.

Ferner ist es vorteilhaft, die Zielfunktion einer globalen Minimierung zu unterziehen, da durch diese Vorgehensweise die in dem elektrischen Signal enthaltene Information im Rahmen der Optimierung und somit auch bei der Ermittlung des Signalwerts optimal ausgenutzt wird.

Es ist ferner vorteilhaft, daß das elektrische Signal ein Funksignal ist und somit die Anordnung ein Funkübertragungssystem mit einer erfindungsgemäße Anordnung ist, da das Verfahren gerade im Bereich der Funkübertragung, insbesondere bei der Übertragung von Funksignalen durch eine Raumsonde erhebliche Einsparungen ermöglicht.

Das Verfahren kann ferner vorteilhaft eingesetzt werden bei der Archivierung und Rekonstruktion archivierter gespeicherter digitaler Daten, die in einem Speichermedium (z.B. Magnetbandspeicher, Festplattenspeicher, etc.), da auch bei dieser Anwendung ein verbessertes Signal-/Rausch-Verhältnis von erheblicher Bedeutung ist.

In den Figuren sind Ausführungsbeispiele der Erfindung beschrieben, die im weiteren näher erläutert werden.

Es zeigen

Fig. 1    ein Ablaufdiagramm, in dem das Verfahren, welches in einer Recheneinheit durchgeführt wird, in seinen einzelnen Verfahrensschritten dargestellt ist;

Fig. 2    ein Blockschaltbild, bei dem das Senden, das Übertragen und das Empfangen des elektrischen Signals dargestellt ist;

Fig. 3    eine Skizze eines Funkübertragungssystems;

Fig. 4    eine Skizze eines Archivierungssystems zur Archivierung digitaler Daten.

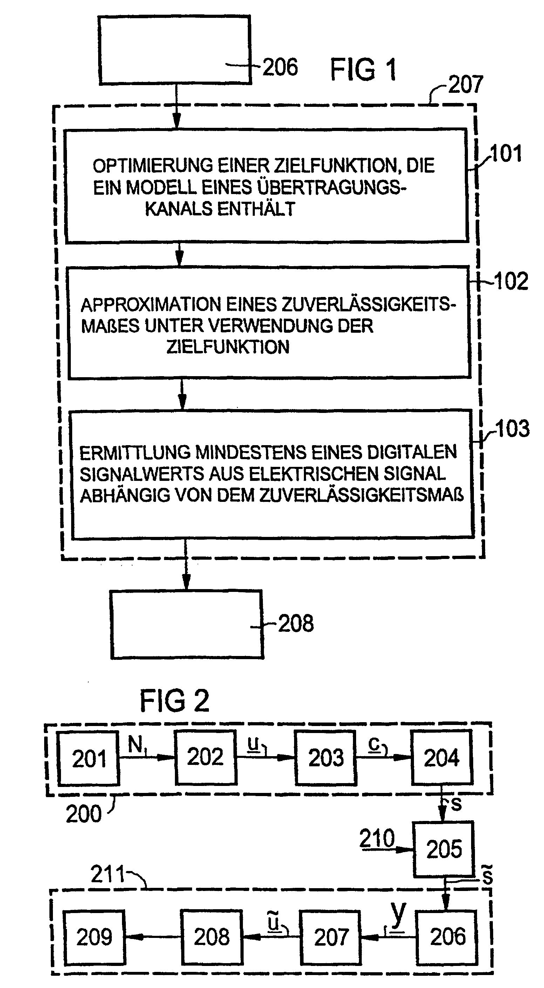

In Fig. 2 ist symbolisch eine Quelle 201 dargestellt, von der aus eine Nachricht N zu einer Senke 209 übertragen werden soll.

Die zu übertragende Nachricht N wird einem Quellencodierer 202 zugeführt, wo sie derart komprimiert wird, daß zwar keine Informationen verloren gehen, aber für die Decodierung der Nachricht überflüssige Redundanzinformation eliminiert wird und somit die benötigte Übertragungskapazität verringert wird.

Ausgabe des Quellencodierers 202 ist das Codewort $\underline{u} \in \{\pm 1\}^k$, das aus einer Folge digitaler Werte besteht. Dabei ist für jedes Codewort $\underline{u}$ vorausgesetzt, daß jeder Wert $u_i$, i=1,...k des Codewortes $\underline{u}$ mit gleicher Wahrscheinlichkeit einen ersten Wert (logisch "0" oder logisch "+1") bzw. einen zweiten Wert (logisch "1" oder logisch "-1") annimmt.

Das Codewort $\underline{u}$ wird einer Einheit zur Kanalcodierung 203 zugeführt, in der eine Kanalcodierung des Codewortes $\underline{u}$ erfolgt. Bei der Kanalcodierung wird dem Codewort $\underline{u}$ gezielt Redundanzinformation hinzugefügt, um bei der Übertragung möglicherweise entstehende Übertragungsfehler korrigieren oder zumindest erkennen zu können, und somit eine hohe Übertragungszuverlässigkeit zu erreichen.

Im weiteren wird davon ausgegangen, daß durch die Kanalcodierung jedem Codewort $\underline{u} \in \{\pm 1\}^k$ ein Kanalcodewort $\underline{c} \in \{\pm 1\}^n$ zugeordnet wird. Die Ausgabe der Einheit zur Kanalcodierung 203 besteht somit aus dem Kanalcodewort $\underline{c} \in \{\pm 1\}^n$.

Das Kanalcodewort $\underline{c} \in \{\pm 1\}^n$ wird einer Einheit zur Modulation 204 des Kanalcodewortes $\underline{c}$ zugeführt. Bei

der Modulation wird dem Kanalcodewort $\underline{c}$ eine für die Übertragung über einen physikalischen Kanal 205 geeignete Funktion s: $\Re \to \Re$ zugeordnet.

Das zu übertragende Signal enthält also sowohl Signalinformation, d.h. das Kanalcodewort $\underline{c}$ als auch aus der Signalimformation ermittelte Redundanzinformation, d.h. zusätzlich sog. Prüfwerte. Das modulierte Signal s wird über den physikalischen Kanal 205 zu einer Empfängereinheit übertragen. Bei der Übertragung über den physikalischen Kanal 205 tritt häufig eine Störung 210 auf, die das modulierte Signal s verfälscht. Somit liegt bei der Empfängereinheit ein verändertes moduliertes Signal s an, welches Einheit zur Demodulation 206 zugeführt wird.

In der Einheit zur Demodulation 206 erfolgt eine Demodulation des veränderten modulierten Signals $\tilde{s}$. Ausgabe der Demodulation ist eine im weiteren als elektrisches Signal bezeichneter Vektor $\underline{y} \in \Re^n$, welcher das digitale, demodulierte veränderte Signal $\tilde{s}$ beschreibt.

Im Rahmen der weiteren Betrachtungen wird zur Modellierung des physikalischen Kanals 205 das Modell des sog. AWGN-Kanals, wie oben beschrieben wurde, verwendet. Zur Vereinfachung wird im weiteren sowohl die Einheit zur Modulation 204 als auch die Einheit zur Demodulation 206 des Senders 200 bzw. des Empfängers 211 in dem Modell des Übertragungskanals mit berücksichtigt.

Das elektrische Signal $\underline{y}$ wird in einer Einheit zur Kanaldecodierung 207 einer Kanaldecodierung unterzogen. Vektorkomponenten $y_i$ des elektrischen Signals $\underline{y}$ enthalten sowohl eine Vorzeicheninformation als auch eine Betragsinformation.

Die Betragsinformation ist jeweils der Absolutbetrag der Vektorkomponente $y_i$, der auch als Zuverlässigkeitsinformation für das entsprechende Vorzeichen der Vektorkomponente $y_i$ bezeichnet wird.

Bei der Kanaldecodierung besteht die Aufgabe, eine sog. Soft-Decision-Decodierung durchzuführen. Dies bedeutet, daß zum einen ein rekonstruiertes Codewort $\tilde{u}$ rekonstruiert wird und ferner für jede Komponente eine Zuverlässigkeitsinformation ermittelt wird, das die getroffene Entscheidung zur Rekonstruktion einer Komponente $\tilde{u}_i$ des rekonstruierten Codeworts $\tilde{u}$ beschreibt. Eine Komponente $\tilde{u}_i$ des rekonstruierten Codeworts $\tilde{u}$ wird im weiteren als digitaler Signalwert bezeichnet.

Das rekonstruierte Codewort $\tilde{u}$, d.h. mindestens ein digitaler Signalwert wird einer Einheit zur Quellendecodierung 208 zugeführt, in der eine Quellendecodierung erfolgt. Das decodierte Signal wird schließlich der Senke 209 zugeführt.

In Fig. 1 ist die Kanaldecodierung 207 detaillierter in Form eines Ablaufdiagramms beschrieben.

In einem ersten Schritt 101 wird eine Zielfunktion f, die ein nichtlineares Regressionsmodell des Übertragungskanals 204, 205, 206, enthält, optimiert.

Im weiteren wird zur Veranschaulichung das nichtlineare Regressionsmodell hergeleitet.

Aus der oben beschriebenen Vorschrift (16) zur exakten Ermittlung des Zuverlässigkeitsmaßes:

$$L\left(U_i \mid \underline{y}\right) = \ln\left(\frac{\displaystyle\sum_{\substack{\underline{v} \in C \\ v_i = +1}} \exp\left(-\frac{(\underline{y} - \underline{v})^T(\underline{y} - \underline{v})}{\dfrac{N_0 n}{E_b k}}\right)}{\displaystyle\sum_{\substack{\underline{v} \in C \\ v_i = -1}} \exp\left(-\frac{(\underline{y} - \underline{v})^T(\underline{y} - \underline{v})}{\dfrac{N_0 n}{E_b k}}\right)}\right) \qquad (16),$$

wobei mit

- $N_0$ eine einseitige Rauschleistungsdichte,
- n eine Anzahl von in dem Signal enthaltenen digitalen Signalwerten,
- $E_b$ eine mittlere Signalenergie für einen der k Signalwerte, d.h. der Informationsbits,
- k eine Anzahl in dem elektrischen Signal enthaltener digitaler Signalwerte,
- $\underline{y}$ ein Vektor aus $\Re^n$, welcher das Signal beschreibt,
- C die Menge aller Kanalcodeworte,
- $\underline{C}$ eine n-dimensionale Zufallsgröße zur Beschreibung des Signalwerts,
- $\underline{v}$ ein Vektor aus C,
- i ein Index zur eindeutigen Bezeichnung des Signalwerts $v_i$,

- $U_i$ eine Zufallsvariable des Signalwerts $\upsilon_i$,

-

$$L\left(U_i \big| \underline{y}\right)$$

das Zuverlässigkeitsmaß,
- $J_i$ eine Menge digitaler Werte der Redundanzinformation, und
- j ein weiterer Index

bezeichnet wird,
lassen sich im Zähler der Faktor

$$\exp\left(-\frac{(y_i - 1)^2}{\dfrac{N_0 n}{E_b k}}\right) \tag{18}$$

und im Nenner der Faktor

$$\exp\left(-\frac{(y_i + 1)^2}{\dfrac{N_0 n}{E_b k}}\right) \tag{19}$$

ausklammern.

Nach der Ausklammerung ergibt sich für alle i = 1,...,k mit entsprechenden Faktoren $\tau_i$, die nun nicht mehr von den Komponenten $y_i$ des elektrischen Signals abhängen, folgende Vorschrift:

$$L\left(U_i \big| \underline{y}\right) = \ln \frac{\exp\left(-\dfrac{(y_i - 1)^2}{\dfrac{N_0 n}{E_b k}}\right)}{\exp\left(-\dfrac{(y_i + 1)^2}{\dfrac{N_0 n}{E_b k}}\right)} + \tau_i = \frac{4 E_b k}{N_0 n} y_i + \tau_i \tag{20}.$$

Für i = k + 1, ..., n gilt:

$$L\left(\bigoplus_{j \in J_i} U_j \Big| \underline{y}\right) = \frac{4E_b k}{N_0 n} y_i + \tau_i \qquad (21).$$

Wäre der physikalische Kanal 205 nicht gestört, dann würde für i = 1, ..., k allein die Beobachtung der jeweiligen Komponente $y_i$ des elektrischen Signals genügen, um die Verteilung von $U_i$ unter der Bedingung, daß die Zufallsvariable $\underline{Y}$ den Wert $\underline{y}$ annimmt, festzulegen. Somit wären alle Faktoren $\tau_i = 0$. Analog verhält es sich für i = k + 1, ..., n mit der Verteilung

$$\bigoplus_{j \in J_i}$$

$U_j$ unter der Bedingung, daß die Zufallsvariable $\underline{Y}$ den Wert $\underline{y}$ annimmt. Auch in diesem Fall wären alle Faktoren $\tau_i = 0$. Somit sind die Absolutbeträge der Faktoren $\tau_1$, ..., $\tau_n$ ein Maß für die Kanalstörung.

Unter der Bedingung, daß das Signal $\underline{y}$ empfangen wurde, geht die stochastische Unabhängigkeit der Variablen $U_1, ..., U_k$, verloren.

Es gilt somit für i = k + 1, ..., n mit entsprechendem Fehlerfaktor $\rho_i$:

$$L\left(\bigoplus_{j \in J_i} U_j \Big| \underline{y}\right) = \ln\left(\frac{1 + \prod_{j \in J_i} \dfrac{\exp\left(L\left(U_j|\underline{y}\right)\right) - 1}{\exp\left(L\left(U_j|\underline{y}\right)\right) + 1}}{1 - \prod_{j \in J_i} \dfrac{\exp\left(L\left(U_j|\underline{y}\right)\right) - 1}{\exp\left(L\left(U_j|\underline{y}\right)\right) + 1}}\right) + \rho_i \qquad (22).$$

Auch für die Fehlerfaktoren $\rho_{k+1}$, ..., $\rho_n$ ist offensichtlich, daß alle $\rho_{k+1}$, ..., $\rho_n$ gleich 0 gesetzt werden können, falls der physikalische Kanal nicht gestört ist.

Insgesamt ergibt sich folgende Vorschrift:

$$\frac{4E_b k}{N_0 n} \underline{y} = \begin{pmatrix} L(U_1|\underline{y}) \\ \vdots \\ L(U_k|\underline{y}) \\ \ln\left(\dfrac{1 + \displaystyle\prod_{j \in J_{k+1}} \dfrac{\exp(L(U_j|\underline{y})) - 1}{\exp(L(U_j|\underline{y})) + 1}}{1 - \displaystyle\prod_{j \in J_{k+1}} \dfrac{\exp(L(U_j|\underline{y})) - 1}{\exp(L(U_j|\underline{y})) + 1}}\right) \\ \vdots \\ \ln\left(\dfrac{1 + \displaystyle\prod_{j \in J_n} \dfrac{\exp(L(U_j|\underline{y})) - 1}{\exp(L(U_j|\underline{y})) + 1}}{1 - \displaystyle\prod_{j \in J_n} \dfrac{\exp(L(U_j|\underline{y})) - 1}{\exp(L(U_j|\underline{y})) + 1}}\right) \end{pmatrix} - \begin{pmatrix} \tau_1 \\ \vdots \\ \tau_k \\ \tau_{k+1} - \rho_{k+1} \\ \vdots \\ \tau_n - \rho_n \end{pmatrix}$$

(23).

Ersetzt man nun die Werte

$$\text{für } i = 1, \ldots, k \quad L(U_i|\underline{y}) = \beta_i; \quad -\tau_i = e_i$$
$$\text{für } i = k+1, \ldots, n \quad \rho_i - \tau_i = e_i$$

(24),

so folgt daraus das folgende nichtlineare Regressionsproblem:

$$\frac{4E_b k}{N_0 n}\,\underline{y} = \begin{pmatrix} \beta_1 \\ \vdots \\ \beta_k \\ \ln\left( \dfrac{1 + \displaystyle\prod_{j \in J_{k+1}} \dfrac{\exp(\beta_j) - 1}{\exp(\beta_j) + 1}}{1 - \displaystyle\prod_{j \in J_{k+1}} \dfrac{\exp(\beta_j) - 1}{\exp(\beta_j) + 1}} \right) \\ \vdots \\ \ln\left( \dfrac{1 + \displaystyle\prod_{j \in J_n} \dfrac{\exp(\beta_j) - 1}{\exp(\beta_j) + 1}}{1 - \displaystyle\prod_{j \in J_n} \dfrac{\exp(\beta_j) - 1}{\exp(\beta_j) + 1}} \right) \end{pmatrix} + \underline{e} \qquad (25).$$

Da ein Fehlervektor $\underline{e}$ gleich dem Nullvektor ist, falls keine Störung des physikalischen Kanals gegeben ist und aufgrund des stochastischen Modells der Kanalstörung wird vorausgesetzt, daß der Fehlervektor $\underline{e}$ eine Realisierung einer Zufallsvariablen $\underline{E}: \Omega \to \mathfrak{R}^n$ ist mit Erwartungswert $E(\underline{E}=0)$. Die Zuverlässigkeitsmaße werden also durch Minimierung des Einflusses der Kanalstörung approximiert.

Jeweils ein Zuverlässigkeitsmaß dient zur Rekonstruktion jeweils eines digitalen Signalwerts.

Das nichtlineare Regressionsproblem wird durch eine Zielfunktion f formuliert und gelöst, wenn die Zielfunktion f optimiert, in diesem Fall minimiert wird.

Die Zielfunktion f wird nach folgender Vorschrift gebildet:

$$\min\left\{ \underline{e}(\beta)^T \underline{e}(\beta) \right\} = \min\{f\}$$

mit

$$f = \sum_{i=1}^{k} \left( \beta_i - \frac{4E_b k}{N_0 n} y_i \right)^2 + \sum_{i=k+1}^{n} \left( \ln\left( \frac{1 + \displaystyle\prod_{j \in J_i} \dfrac{\exp(\beta_j) - 1}{\exp(\beta_j) + 1}}{1 - \displaystyle\prod_{j \in J_i} \dfrac{\exp(\beta_j) - 1}{\exp(\beta_j) + 1}} \right) - \frac{4E_b k}{N_0 n} y_i \right)^2 \qquad (26).$$

Die Lösung des nichtlinearen Regressionsproblems erfolgt durch Minimierung der Zielfunktion f.

Für die Minimierung der Zielfunktion f wird ein Verfahren zur globalen Minimierung, welches aus [4] bekannt ist, verwendet.

Die Zielfunktion f ist im allgemeinen nicht konvex und deshalb ist es vorteilhaft, zur Minimierung der Zielfunktion einen Algorithmus zur globalen Minimierung einzusetzen, weil es auf diese Weise möglich ist, die gegebenen Informationen im Sinne der Informationstheorie optimal auszunutzen.

Für die Komponenten $y_i$ des elektrischen Signals $\underline{y}$ wird unter Verwendung eines neuronalen Netzes, dessen Struktur sich durch die ermittelten Parameter der optimierten Zielfunktion f ergeben, jeweils ein Zuverlässigkeitsmaß approximiert (Schritt 102).

In einem letzten Schritt 103 wird der digitale Signalwert bzw. die digitalen Signalwerte $\tilde{u}_i$ aus dem elektrischen Signal $\underline{y}$ abhängig von dem Zuverlässigkeitsmaß ermittelt. Dabei wird als Kriterium zur Zuordnung des ersten bzw. des zweiten Wertes zu dem digitalen Signalwert $\tilde{u}_i$ die Vorzeicheninformation des jeweiligen Zuverlässigkeitsmaßes verwendet.

Weist das Zuverlässigkeitsmaß einen Wert größer 0 auf, so wird dem digitalen Signalwert $\tilde{u}_i$ der zweite Wert (logisch "1" oder logisch "-1") zugeordnet und weist das Zuverlässigkeitsmaß einen Wert kleiner 0 auf, so wird dem digitalen Signalwert $\tilde{u}_i$ der erste Wert (logisch "0" bzw. logisch "+1") zugeordnet.

Dies wird für alle zu rekonstruierenden digitalen Signalwerte $\tilde{u}_i$ durchgeführt, deren Rekonstruktion erwünscht ist.

Die Anordnung zur Kanaldecodierung 207 ist derart ausgestaltet, daß das oben beschriebene Verfahren durchgeführt wird. Dies kann durch Programmierung einer Recheneinheit oder auch durch eine auf das Verfahren abgestimmte elektrische Schaltung erfolgen.

Im weiteren werden einige Alternativen und Verallgemeinerungen des oben beschriebenen Verfahrens bzw. der Anordnung aufgezeigt:

Es ist nicht notwendig, eine globale Minimierung der Zielfunktion durchzuführen. Die Minimierung kann ebenfalls durch ein Verfahren zur lokalen Minimierung erfolgen, z.B mittels des sog. BFGS-Verfahrens (Broyden, Fletcher, Goldfarb, Shanno-Verfahren). Auch ist die Minimierung der Zielfunktion nicht auf das in [4] beschriebene Verfahren beschränkt. Weitere Verfahren zur Minimierung können ebenso eingesetzt werden.

Auch ist es nicht erforderlich, daß als Zielfunktion eine quadratische Norm minimiert wird, allgemein kann jede beliebige Norm des Vektors e(β) eingesetzt werden.

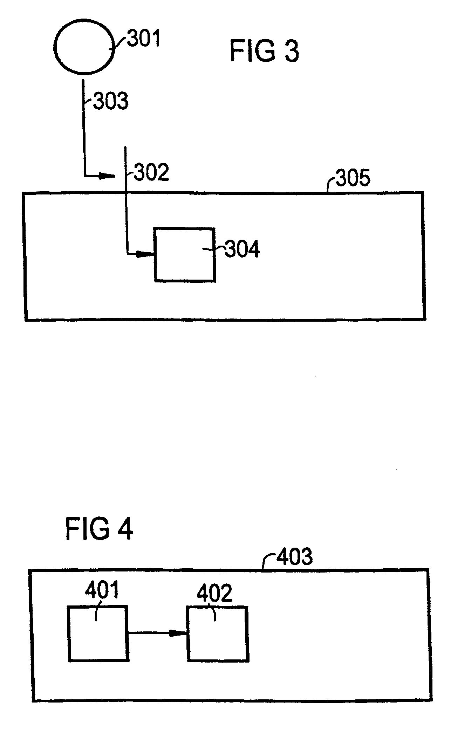

In Fig. 3 ist ein Funkübertragungssystem dargestellt, welches eine Anordnung mit den oben beschriebenen Merkmalen enthält. Eine Sendeeinrichtung 301, vorzugsweise eine Raumsonde überträgt ein Funksignal 303 über einen physikalischen Kanal 205, in diesem Fall durch Luft. Das Funksignal 303 wird über eine Antenne 302 der Empfängeranordnung 305 empfangen und als elektrisches Signal der Anordnung 304 zugeführt, die das Mittel zur Demodulation 206, das Mittel zur Kanaldecodierung 207, sowie das Mittel zur Quellendecodierung 208 enthält.

In Fig. 4 ist ein System 403 zur Rekonstrion archivierter digitaler Daten dargestellt. In einem Speicher 401, z.B. einem magnetischer Speicher (Magnetbandspeicher, Festplattenspeicher, etc.) werden digitale Daten archiviert. Bei der Rekonstruktion kann unter Verwendung einer Anordnung mit dem Mittel zur Kanaldecodierung 207 das oben beschriebene Verfahren zur Rekonstruktion des mindestens einen digitalen Signalwerts $\tilde{u}_i$ aus dem elektrischen Signal, welches in diesem Fall aus dem Speicher 401 ausgelesene digitale Signale beschreibt, durchgeführt werden.

Anschaulich ist die Erfindung darin zu sehen, daß das bisher lediglich exakt berechenbare Zuverlässigkeitsmaß approximiert wird.

Im Rahmen dieses Dokumentes wurden folgende Veröffentlichungen zitiert:

[1] B. Friedrichs, Kanalcodierung, Grundlagen und Anwendungen in modernen Kommunikationssystemen, Springer Verlag, ISBN 3-540-59353-5 S. 1-30, 1996

[2] B. Friedrichs, Kanalcodierung, Grundlagen und Anwendungen in modernen Konnumikationssystemen, Springer Verlag, ISBN 3-540-59353-5, Se. 69-125, S. 193-242, 1996

[3] J. Hagenauer et al, Iterative Decoding of Binary Block and Convolutional Codes, IEEE Trans. on Information Theory, Vol. 42, 1996

[4] S. Schäffler, Unconstrained Global Optimization Using Stochastic Integral Equations, Optimization, Vol. 35, S. 43-60, 1995

[5] Yu-Li You and M. Kaveh, "Blind Equalisation by Alternating Minimization for Applications to Mobilecommunications", Globecom '95, IEEE Global Telecommunications Conference, Singapore, Nov. 14-16 1995, Bd. 1. Seiten 88-92, XP621461

**Patentansprüche**

1. Verfahren zur Ermittlung mindestens eines digitalen Signalwerts aus einem elektrischen Signal, welches Signalinformation und aus der Signalinformation ermittelte Redundanzinformation zu der Signalinformation enthält,

   - bei dem aus dem elektrischen Signal ein Zuverlässigkeitsmaß zur Bildung des Signalwerts approximiert wird, wobei die Approximation des Zuverlässigkeitsmaßes derart erfolgt, daß eine Zielfunktion, die ein nichtlineares Regressionsmodell eines Übertragungskanals enthält, über den das elektrische Signal übertragen wurde, optimiert wird, und
   - bei dem abhängig von dem jeweiligen Zuverlässigkeitsmaß der digitale Signalwert ermittelt wird.

2. Verfahren nach Anspruch 1,
   bei dem mehrere digitale Signalwerte aus dem elektrischen Signal ermittelt werden.

3. Verfahren nach Anspruch 1 oder 2,
   bei dem die Zielfunktion nach folgender Vorschrift gebildet wird:

$$f = \sum_{i=1}^{k}\left(\beta_i - \frac{4E_b k}{N_0 n}y_i\right)^2 + \sum_{i=k+1}^{n}\left(\ln\left(\frac{1 + \prod\limits_{j\in J_i}\frac{\exp(\beta_j) - 1}{\exp(\beta_j) + 1}}{1 - \prod\limits_{j\in J_i}\frac{\exp(\beta_j) - 1}{\exp(\beta_j) + 1}}\right) - \frac{4E_b k}{N_0 n}\right)^2$$

mit

$$\beta_i = L(u_i|\underline{y}),$$

und mit

$$L(u_i|\underline{y}) = \ln\frac{\sum\limits_{\substack{\underline{v}\in C \\ v_i = +1}}\exp\left(-\frac{(\underline{y} - \underline{v})^T(\underline{y} - \underline{v})}{\frac{N_0 n}{E_b k}}\right)}{\sum\limits_{\substack{\underline{v}\in C \\ v_1 = -1}}\exp\left(-\frac{(\underline{y} - \underline{v})^T(\underline{y} - \underline{v})}{\frac{N_0 n}{E_b k}}\right)},$$

wobei mit

   - $N_0$ eine einseitige Rauschleistungsdichte,
   - $n$ eine Anzahl von in dem Signal enthaltenen digitalen Signalwerten,
   - $E_b$ eine mittlere Signalenergie für einen der k Signalwerte,

- k eine Anzahl in dem elektrischen Signal enthaltener digitaler Signalwerte,
- $\underline{y}$ ein Vektor aus $\mathfrak{R}^n$ , welcher das Signal beschreibt,
- C die Menge aller Kanalcodeworte,
- $\underline{C}$ eine n-dimensionale Zufallsgröße zur Beschreibung des Signalwerts,
- $\underline{v}$ ein Vektor aus C,
- i ein Index zur eindeutigen Bezeichnung des Signalwerts $U_i$,
- $U_i$ eine Zufallsvariable des Signalwerts $U_i$,
-

$$L\left(U_i \middle| \underline{y}\right)$$

das Zuverlässigkeitsmaß,
- $J_i$ eine Menge digitaler Werte der Redundanzinformation, und
- j ein weiterer Index

bezeichnet wird.

**4.** Verfahren nach einem der Ansprüche 1 bis 3,
bei dem die Zielfunktion einer globalen Minimierung unterzogen wird.

**5.** Verfahren nach einem der Ansprüche 1 bis 4,

- bei dem das Zuverlässigkeitsmaß eine Vorzeicheninformation und eine Betragsinformation aufweist, und
- bei dem die Ermittlung des Signalwerts nur abhängig von der Vorzeicheninformation erfolgt.

**6.** Verfahren nach einem der Ansprüche 1 bis 5,
bei dem das elektrische Signal ein systematischer Blockcode ist.

**7.** Verfahren nach einem der Ansprüche 1 bis 6,
bei dem das elektrische Signal ein Funksignal ist.

**8.** Verfahren nach einem der Ansprüche 1 bis 7,
bei dem das elektrische Signal ein restauriertes Signal archivierter digitaler Daten ist.

**9.** Anordnung zur Ermittlung mindestens eines digitalen Signalwerts aus einem elektrischen Signal, welches Signalinformation und aus der Signalinformation ermittelte Redundanzinformation zu der Signalinformation enthält, mit einer Recheneinheit, die derart eingereichtet ist,

- daß aus dem elektrischen Signal ein Zuverlässigkeitsmaß zur Bildung des Signalwerts approximiert wird, wobei die Approximation des Zuverlässigkeitsmaßes derart erfolgt, daß eine Zielfunktion, die ein nichtlineares Regressionsmodell eines Übertragungskanals enthält, über den das elektrische Signal übertragen wurde, optimiert wird, und
- daß abhängig von dem jeweiligen Zuverlässigkeitsmaß der digitale Signalwert ermittelt wird.

**10.** Anordnung nach Anspruch 9,
mit einer Empfängereinheit zum Empfangen des elektrischen Signals und zur Zuführung des elektrischen Signals zur der Recheneinheit.

**11.** Anordnung nach Anspruch 10,
mit einer Demodulatoreinheit zur Demodulation des elektrischen Signals, die über einen Eingang mit der Empfängereinheit und über einen Ausgang mit der Recheneinheit verbunden ist.

**12.** Anordnung nach Anspruch 10 oder 11,
bei der die Empfängereinheit eine Antenne aufweist.

**13.** Anordnung nach einem der Ansprüche 9 bis 12,
bei der die Recheneinheit derart eingerichtet ist, daß mehrere digitale Signalwerte aus dem elektrischen Signal ermittelt werden.

**14.** Anordnung nach Anspruch 9, bei der die Recheneinheit derart eingerichtet ist,

- daß die Zielfunktion nach folgender Vorschrift gebildet wird:

$$f = \sum_{i=1}^{k} \left( \beta_i - \frac{4E_b k}{N_0 n} y_i \right)^2 + \sum_{i=k+1}^{n} \left( \ln \frac{1 + \prod_{j \in J_i} \frac{\exp(\beta_j) - 1}{\exp(\beta_j) + 1}}{1 - \prod_{j \in J_i} \frac{\exp(\beta_j) - 1}{\exp(\beta_j) + 1}} - \frac{4E_b k}{N_0 n} \right)^2$$

$$\beta_i = L(U_i | \underline{y}),$$

und mit

$$L(U_i | \underline{y}) = \ln \frac{\sum_{\substack{\underline{v} \in C \\ v_i = +1}} \exp\left( - \frac{(\underline{y} - \underline{v})^T (\underline{y} - \underline{v})}{\frac{N_0 n}{E_b k}} \right)}{\sum_{\substack{\underline{v} \in C \\ v_1 = -1}} \exp\left( - \frac{(\underline{y} - \underline{v})^T (\underline{y} - \underline{v})}{\frac{N_0 n}{E_b k}} \right)},$$

wobei mit
- $N_0$ eine einseitige Rauschleistungsdichte,
- n eine Anzahl von in dem Signal enthaltenen digitalen Signalwerten,
- $E_b$ eine mittlere Signalenergie für einen der k Signalwerte,
- k eine Anzahl in dem elektrischen Signal enthaltener digitaler Signalwerte,
- $\underline{y}$ ein Vektor aus $\Re^n$ , welcher das Signal beschreibt,
- C die Menge aller Kanalcodeworte,
- $\underline{C}$ eine n-dimensionale Zufallsgröße zur Beschreibung des Signalwerts,
- $\underline{v}$ ein Vektor aus C,
- i ein Index zur eindeutigen Bezeichnung des Signalwerts $U_i$,
- $U_i$ eine Zufallsvariable des Signalwerts $U_i$,
- 

$$L(U_i | \underline{y})$$

   das Zuverlässigkeitsmaß,
- $J_i$ eine Menge digitaler Werte der Redundanzinformation, und
- j ein weiterer Index

bezeichnet wird.

**15.** Anordnung nach einem der Ansprüche 9 bis 14,
bei der die Recheneinheit derart eingerichtet ist, daß die Zielfunktion einer globalen Minimierung unterzogen wird.

**16.** Anordnung nach einem der Ansprüche 9 bis 15,
welche einem Funkübertragungssystem zugeordnet ist.

**17.** Anordnung nach einem der Ansprüche 9 bis 15,
welche einem System zur Rekonstruktion archivierter digitaler Daten zugeordnet ist.

**Claims**

**1.** Method for determining at least one digital signal value from an electric signal which contains signal information and redundancy information for the signal information which is determined from the signal information,

- in which a reliability measure for forming the signal value is approximated from the electric signal, the approximation of the reliability measure being carried out in such a manner that a target function which contains a non-linear regression model of a transmission channel via which the electric signal has been transmitted is optimized and
- in which the digital signal value is determined in dependence on the respective reliability measure.

**2.** Method according to Claim 1, in which a number of digital signal values are determined from the electric signal.

**3.** Method according to Claim 1 or 2, in which the target function is formed in accordance with the following rule:

$$
f = \sum_{i=1}^{k}\left(\beta_i - \frac{4E_b k}{N_0 n}y_i\right)^2 + \sum_{i=k+1}^{n}\left(\ln\frac{1 + \prod_{j\in J_i}\frac{\exp(\beta_j) - 1}{\exp(\beta_j) + 1}}{1 - \prod_{j\in J_i}\frac{\exp(\beta_j) - 1}{\exp(\beta_j) + 1}} - \frac{4E_b k}{N_0 n}\right)^2
$$

where

$$
\beta_i = L(U_i|\underline{y}),
$$

and where

$$
L(U_i|\underline{y}) = \ln\frac{\sum_{\substack{v\in C\\ v_i=+1}}\exp\left(-\frac{(\underline{y} - \underline{v})^T(\underline{y} - \underline{v})}{\frac{N_0 n}{E_b k}}\right)}{\sum_{\substack{v\in C\\ v_1=-1}}\exp\left(-\frac{(\underline{y} - \underline{v})^T(\underline{y} - \underline{v})}{\frac{N_0 n}{E_b k}}\right)},
$$

where

- $N_0$ is a unilateral noise power density,
- $n$ is a number of digital signal values contained in the signal,
- $E_b$ is a mean signal energy for one of the k signal values,
- $k$ is a number of digital signal values contained in the electrical signal
- $\underline{y}$ is a vector of $R^n$ which describes the signal,

- C is the set of all channel code words,
- $\underline{C}$ is an n-dimensional random quantity for describing the signal value,
- $\underline{v}$ is a vector from C,
- i is an index for the unambiguous designation of the signal value $U_i$,
- $U_i$ is a random variable of the signal value $U_i$,
- $L(U_i|\underline{y})$ is the reliability measure,
- $J_i$ is a set of digital values of the redundancy information, and
- j is a further index

4. Method according to one of Claims 1 to 3, in which the target function is subjected to global minimization.

5. Method according to one of Claims 1 to 4,

- in which the reliability measure has a sign information item and an amount information item and
- in which the signal value is only determined in dependence on the sign information.

6. Method according to one of Claims 1 to 5, in which the electric signal is a systematic block code.

7. Method according to one of Claims 1 to 6, in which the electric signal is a radio signal.

8. Method according to one of Claims 1 to 7, in which the electric signal is a restored signal of archived digital data.

9. Arrangement for determining at least one digital signal value from an electric signal which contains signal information and redundancy information for the signal information which is determined from the signal information, comprises a computing unit which is set up in such a manner that

- a reliability measure for forming the signal value is approximated from the electric signal, the approximation of the reliability measure being carried out in such a manner that a target function which contains a non-linear regression model of a transmission channel via which the electric signal has been transmitted is optimized and
- the digital signal value is determined in dependence on the respective reliability measure.

10. Arrangement according to Claim 9, comprising a receiver unit for receiving the electric signal and for supplying the electric signal to the computing unit.

11. Arrangement according to Claim 10, comprising a demodulator unit for demodulating the electric signal which is connected to the receiver unit via an input and to the computing unit via an output.

12. Arrangement according to Claim 10 or 11 in which the receiver unit has an antenna.

13. Arrangement according to one of Claims 9 to 12, in which the computing unit is set up in such a manner that a number of digital signal values are determined from the electric signal.

14. Arrangement according to Claim 9, in which the computing unit is set up in such a manner that

- the target function is formed in accordance with the following rule:

$$
f = \sum_{i=1}^{k}\left( B_i - \frac{4E_b k}{N_0 n} y_i \right)^2 + \sum_{i=k+1}^{n}\left( \ln \frac{1 + \prod_{j \in J_i} \frac{\exp(B_j) - 1}{\exp(B_j) + 1}}{1 - \prod_{j \in J_i} \frac{\exp(B_j) - 1}{\exp(B_j) + 1}} - \frac{4E_b k}{N_0 n} \right)^2
$$

$$B_i = L(U_i|\underline{y}),$$

and where

$$L(U_i|\underline{y}) = \ln\left(\frac{\sum\limits_{\substack{\underline{v}\in C \\ v_i=+1}} \exp\left(-\frac{(\underline{y}-\underline{v})^T(\underline{y}-\underline{v})}{\frac{N_0 n}{E_b k}}\right)}{\sum\limits_{\substack{\underline{v}\in C \\ v_1=-1}} \exp\left(-\frac{(\underline{y}-\underline{v})^T(\underline{y}-\underline{v})}{\frac{N_0 n}{E_b k}}\right)}\right),$$

where
- $N_0$ is a unilateral noise power density,
- n is a number of digital signal values contained in the signal,
- $E_b$ is a mean signal energy for one of the k signal values,
- k is a number of digital signal values contained in the electrical signal
- $\underline{y}$ is a vector of $R^n$ which describes the signal,
- C is the set of all channel code words,
- $\underline{C}$ is an n-dimensional random quantity for describing the signal value,
- $\underline{v}$ is a vector from C,
- i is an index for the unambiguous designation of the signal value $U_i$,
- $U_i$ is a random variable of the signal value $U_i$,
- $L(U_i|\underline{y})$ is the reliability measure,
- $J_i$ is a set of digital values of the redundancy information, and
- j is a further index

15. Arrangement according to one of Claims 9 to 14, in which the computing unit is set up in such a manner that the target function is subjected to a global minimization.

16. Arrangement according to one of Claims 9 to 15, which is allocated to a radio transmission system.

17. Arrangement according to one of Claims 9 to 15, which is allocated to a system for reconstructing archived digital data.

**Revendications**

1. Procédé pour déterminer au moins une valeur de signal numérique à partir d'un signal électrique qui renferme une information de signal et une information de redondance, correspondant à l'information du signal et déterminée à partir de l'information du signal,

 - au cours duquel on approche par approximation, à partir du signal électrique, une dimension de fiabilité pour former la valeur du signal, l'approximation de la dimension de fiabilité étant effectuée de telle sorte qu'une fonction de performance, qui contient un modèle de régression non linéaire d'un canal de transmission, sur lequel le signal électrique a été transmis, est optimisée et
 - au cours duquel une valeur numérique du signal est déterminée à partir de la dimension de fiabilité respective.

**2.** Procédé selon la revendication 1
au cours duquel plusieurs valeurs numériques du signal sont déterminées à partir du signal électrique.

**3.** Procédé selon la revendication 1 ou 2
au cours duquel la fonction de performance est formée conformément à la règle suivante:

$$f = \sum_{i=1}^{k} \left( \beta_i - \frac{4E_b k}{N_0 n} y_i \right)^2 + \sum_{i=k+1}^{n} \left( \ln \left( \frac{1 + \prod_{j \in J_i} \frac{\exp(\beta_j) - 1}{\exp(\beta_j) + 1}}{1 - \prod_{j \in J_i} \frac{\exp(\beta_j) - 1}{\exp(\beta_j) + 1}} \right) - \frac{4E_b k}{N_0 n} \right)^2$$

avec

$$\beta_i = L(U_i | \underline{y}),$$

et avec

$$L(U_i | \underline{y}) = \ln \left( \frac{\sum_{\substack{\underline{v} \in C \\ v_i = +1}} \exp \left( - \frac{(\underline{y} - \underline{v})^T (\underline{y} - \underline{v})}{\frac{N_0 n}{E_b k}} \right)}{\sum_{\substack{\underline{v} \in C \\ v_i = -1}} \exp \left( - \frac{(\underline{y} - \underline{v})^T (\underline{y} - \underline{v})}{\frac{N_0 n}{E_b k}} \right)} \right)$$

dans lesquelles les symboles ont la signification suivante:

- $N_0$ : une densité unilatérale de la puissance de bruit,
- $n$ : un nombre de valeurs numériques du signal contenues dans le signal,
- $E_b$ : une énergie moyenne du signal pour une des valeurs k du signal,
- $k$ : un nombre de valeurs numériques du signal contenues dans le signal électrique,
- $\underline{y}$ : un vecteur composé de $\mathfrak{R}^n$ et qui décrit le signal,
- $C$ : l'ensemble de tous les mots de code du canal,
- $\underline{C}$ : une grandeur aléatoire à n dimensions pour la description de la valeur du signal,
- $\underline{v}$ : un vecteur composé de C,
- $i$ : un indice pour la désignation univoque de la valeur du signal $U_i$,
- $U_i$ : une variable aléatoire du la valeur du signal $U_i$,
- $L(U_i | \underline{y})$ : la dimension de fiabilité,
- $J_i$ : un ensemble de valeurs numériques de l'information de redondance et
- $j$ : un indice supplémentaire.

**4.** Procédé selon l'une des revendications 1 à 3
au cours duquel la fonction de performance est soumise à une minimisation globale.

**5.** Procédé selon l'une des revendications 1 à 4

- au cours duquel la dimension de fiabilité comporte une information de signe et une information de valeur et
- au cours duquel la détermination de la valeur du signal n'est exécutée qu'en fonction de l'information de signe.

**6.** Procédé selon l'une des revendications 1 à 5
dans lequel le signal électrique est un code systématique par blocs.

**7.** Procédé selon l'une des revendications 1 à 6
dans lequel le signal électrique est un signal par radio.

**8.** Procédé selon l'une des revendications 1 à 7
dans lequel le signal électrique est un signal restauré de données numériques archivées.

**9.** Dispositif pour déterminer au moins une valeur de signal numérique à partir d'un signal électrique qui renferme
une information de signal et une information de redondance, correspondant à l'information du signal et déterminée
à partir de l'information du signal,
avec une unité de calcul réglée de telle sorte

- qu'on approche par approximation, à partir du signal électrique, une dimension de fiabilité pour former la valeur
du signal, l'approximation de la dimension de fiabilité étant effectuée de telle sorte qu'une fonction de performance, qui contient un modèle de régression non linéaire d'un canal de transmission, sur lequel le signal
électrique a été transmis, est optimisée et
- qu'on détermine la valeur numérique du signal à partir de la dimension de fiabilité respective.

**10.** Dispositif selon la revendication 9
avec une unité réceptrice pour la réception du signal électrique et pour appliquer le signal électrique sur l'unité de
calcul.

**11.** Dispositif selon la revendication 10
avec une unité de démodulation pour démoduler le signal électrique, laquelle est reliée, via une entrée, à l'unité
réceptrice et, via une sortie, à l'unité de calcul.

**12.** Dispositif selon la revendication 10 ou 11
dans lequel l'unité réceptrice comporte une antenne.

**13.** Dispositif selon l'une des revendications 9 à 12
dans lequel l'unité de calcul est réglée de telle sorte que plusieurs valeurs numériques du signal sont déterminées
à partir du signal électrique.

**14.** Dispositif selon la revendication 9
dans lequel l'unité de calcul est réglée de telle sorte

- que la fonction de performance est formée conformément à la règle suivante:

$$f = \sum_{i=1}^{k}\left(\beta_i - \frac{4E_b k}{N_0 n} y_i\right)^2 + \sum_{i=k+1}^{n}\left(\ln\left(\frac{1 + \prod_{j \in J_i} \frac{\exp(\beta_j) - 1}{\exp(\beta_j) + 1}}{1 - \prod_{j \in J_i} \frac{\exp(\beta_j) - 1}{\exp(\beta_j) + 1}}\right) - \frac{4E_b k}{N_0 n}\right)^2$$

avec

$$B_i = L\left(U_i|\underline{y}\right),$$

et avec

$$L\left(U_i|\underline{y}\right) = \ln\left[\frac{\sum\limits_{\substack{\underline{v}\in C \\ v_1=+1}} \exp\left(-\frac{(\underline{y}-\underline{v})^T(\underline{y}-\underline{v})}{\frac{N_0 n}{E_b k}}\right)}{\sum\limits_{\substack{\underline{v}\in C \\ v_1=-1}} \exp\left(-\frac{(\underline{y}-\underline{v})^T(\underline{y}-\underline{v})}{\frac{N_0 n}{E_b k}}\right)}\right]$$

dans lesquelles les symboles ont la signification suivante:

- $N_0$ : une densité unilatérale de la puissance de bruit,
- n : un nombre de valeurs numériques du signal contenues dans le signal,
- $E_b$ : une énergie moyenne du signal pour une des valeurs k du signal,
- k : un nombre de valeurs numériques du signal contenues dans le signal électrique,
- $\underline{y}$ : un vecteur composé de $\Re^n$ et qui décrit le signal,
- C : l'ensemble de tous les mots de code du canal,
- $\underline{C}$ : une grandeur aléatoire à n dimensions pour la description de la valeur du signal,
- $\underline{v}$ : un vecteur composé de C,
- i : un indice pour la désignation univoque de la valeur du signal $U_i$,
- $U_i$ : une variable aléatoire du la valeur du signal $U_i$,
- $L(U_i|\underline{y})$ : la dimension de fiabilité,
- $J_i$ : un ensemble de valeurs numériques de l'information de redondance et
- j : un indice supplémentaire.

15. Dispositif selon l'une des revendications 9 à 14
dans lequel l'unité de calcul est réglée de telle sorte que la fonction de performance est soumise à une minimisation globale.

16. Dispositif selon l'une des revendications 9 à 15
qui est affecté à un système de transmission par radio.

17. Dispositif selon l'une des revendications 9 à 15
qui est affecté à un système de reconstruction de données numériques archivées.

FIG 1

206

207

OPTIMIERUNG EINER ZIELFUNKTION, DIE
EIN MODELL EINES ÜBERTRAGUNGS-
KANALS ENTHÄLT

101

APPROXIMATION EINES ZUVERLÄSSIGKEITS-
MAßES UNTER VERWENDUNG DER
ZIELFUNKTION

102

ERMITTLUNG MINDESTENS EINES DIGITALEN
SIGNALWERTS AUS ELEKTRISCHEN SIGNAL
ABHÄNGIG VON DEM ZUVERLÄSSIGKEITSMAß

103

208

FIG 2

201 $\xrightarrow{N_i}$ 202 $\xrightarrow{\underline{u}_i}$ 203 $\xrightarrow{\underline{c}_i}$ 204

200

$\downarrow s$

210 → 205

$\tilde{\underline{s}}$

211

209 ← 208 $\xleftarrow{\tilde{\underline{u}}}$ 207 $\xleftarrow{\underline{y}}$ 206

FIG 3

FIG 4